# EUROPEAN PATENT SPECIFICATION

(11) **EP 2 829 635 B1**
(45) Date of publication and mention of the grant of the patent: **27.12.2017**
(21) Application number: 13177652.8
(22) Date of filing: 23.07.2013
(51) Int. Cl.: C23C 14/32, C23C 14/54

(54) **Method for controlled production of diffusion based coatings by vacuum cathodic arc systems**
Verfahren zur kontrollierten Herstellung von diffusionsbasierten Beschichtungen durch kathodische Vakuum-Lichtbogensysteme
Procédé de production contrôlée de revêtements à base de diffusion au moyen de systèmes à arc cathodique sous vide

(43) Date of publication of application: 28.01.2015
(73) Proprietor: Oncel, Semih, Istanbul (TR); Ürgen, Mustafa K., Istanbul (TR)
(72) Inventor: Oncel, Semih, Istanbul (TR); Ürgen, Mustafa K., Istanbul (TR)
(74) Representative: Mutlu, Aydin

(56) References cited:
- WO-A1-2011/084573
- WO-A2-2006/099760
- DD-A3- 233 279

## Description

### Technical Field of the Invention

The present invention relates to a novel method for diffusion based treatments of a substrate using electric arc cathode(s), by heating the substrate via emitted electrons *simultaneously* during coating and surface modification procedure. The method of the current invention is carried out in a process chamber which is evacuatable and feedable by any reactive or inert gas, wherein metal, alloy or composite conductive cathode(s) electrically insulated from the chamber are evaporated by cathodic electric arc and wherein the substrate(s) to be treated are connected to an AC or bipolar DC power supply.

### Background of the Invention

Known at present are several types of apparatus employed for PVD coatings. Evaporating or sputtering of source material is realized in these apparatus in various ways (for example by resistive, induction, electron beam, laser, arc heating or diode sputtering, magnetron sputtering, HIPIMS and other techniques).

The electric arc in vacuum deposition *inter alia* is characterized by formation of a cathode spot on the cathode surface through which the arc current flows. Quite naturally, high current density and concentration of energy not only makes for an intensive evaporation of metal in the cathode spot region but also effectively ionize the evaporated atoms. This cathode discharge also emits high amount of electrons.

In order to heat substrates in a vacuum arc coating device, electrons extracted from the arc cathodes can be used by applying an anodic DC voltage to the substrates by a separate DC power supply, as mentioned in U.S. Patent No. 5,294,322. This document, reports general problems of the technology used before, namely heating the substrates by means of metal ion bombardment, serves to heat the substrate to a suitable temperature for the coating process, but causes also uneven mass distribution and geometry, overheating or etching of individual of the substrate, and deposition of macroparticules on the substrate. This patent also reports problems such as inefficiency of gas ion bombardments, namely glow discharge process. By using the electrons extracted from shielded arc cathodes and forwarding them to an auxiliary anode powered by a separate DC power supply, this patent claims to solve macroparticule problems of metal ion bombardment and increase efficiency of glow discharge (gas ion bombardment) process by increasing the ionization of gas molecules. The patent also discloses applying anodic potential directly to the substrates, thus allowing capability of heating substrates by emitting electrons from the arc cathodes.

US Patent No. 5,503,725 discloses a method involving a two-step vacuum arc discharge between an anode and an integrally cold cathode featuring a metal-gaseous step of plasma and a gaseous step of plasma wherein the method further comprises electron separation from the metal-gaseous step of plasma. According to the method, substrate or another evaporator arc source is used as anode. Substrate or another arc source is connected to positive pole of cathode power supply. Additionally, when extra arc source is used as auxiliary anode, substrate can be connected to an additional bias power supply in cathodic polarity to attract positively charged gas ions for etching and surface treatment of substrate. Evaporating cathodic arc sources are shielded by shields.

Aforementioned configurations are used to etch and heat the substrates prior to deposition. For both configurations, evaporating arc cathodes are shielded by shutters or geometric shields and are not in line of sight with substrates. An alternative application is using an auxiliary anode instead of using the substrate as anode, and applying negative bias voltage to the substrate. This technique leads to increased ionization rate of glow discharge plasma treatment, thus can be used to etch materials surface, and to clean and heat the same by gas ion bombardment, and also can be used for gas phase plasma surface treatments such as plasma nitriding, plasma carburizing, etc.

Application of a bipolar pulse bias is also a known technique and is mainly used during glow discharge ion bombardment prior to deposition. In some coating applications it is used for depositing oxide based coatings, but the aim of positive polarity is to decrease charging effect that is observed when DC voltage bias is used.

None of the prior art methods cited above involves use of an electron heating step simultaneously with the coating procedure for coating, surface modification or alloying.

Diffusion based coatings have very wide application areas in the industry. Diffusion coating refers to those applications where components of a coating diffuse and form alloys or compounds between components of substrate, or components of substrate diffuse to the coating and form alloys or compounds between components of a coating.

There are several methods to make diffusion coatings, such as pack cementation, over the pack processes, heat treatments, salt bath treatments, CVD, electrolytic treatments or combination of coating process and post diffusion heat treatments.

NiAl bond coats are one of very common diffusion based coatings especially applied on nickel based superalloys. So formed NiAl phases have high oxidation and corrosion resistance and are used for protecting high temperature alloys and also make a protecting-bonding layer for the post coated thermal barrier coatings.

NiAl diffusion based bond coats are industrially produced by pack aluminisation, over the pack aluminisation and CVD methods. All those are based on the mechanism as follows: Al halide formation, deposition on the substrate and beginning with the diffusion coating process. Those metal halides can be poisonous and dangerous for environment. Expensive and complex exhaust treatment systems are needed especially for CVD processes. Besides, those metal halides sometimes can cause corrosion of the substrate.

All pack, over the pack and CVD processes are hot wall processes that need energy to heat the substrates, treatment media and process chamber, and so all need high energy consumption.

Another disadvantage of those processes is requirement of a long post treatment to convert unwanted phases like Al₃Ni₂ to desired Beta Ni-Al phases.

Alternatively those bond coats can be produced by firstly Al coating of substrate by any conventional method such as dip coating or PVD methods and making the diffusion by post heat treatments. These methods do not need halide formations but still need long post treatments.
Another example of diffusion coatings are formation of carbides, nitrides and carbonitrides on Fe based substrates by different variations of thermal diffusion or Toyota thermodiffusion process as explained in US 3,719,518 and further patents, where the carbon or nitrogen from substrate material diffuse within components of a coating treatment media and forms carbides, nitrides and carbonitrides of metals such as Vanadium, Niobium, Tantalum, Titanium, Chromium, Molybdenum etc. Formation of other carbides is also possible by changing the composition of treatment media.
Variations of this process are widely applied in the industry alone or in combination with heat treatments in order to improve surface properties of substrates such as molds, tools etc. Process time can be between a few hours to tens of hours depending on the required diffusion thickness. However, this process is also a hot wall process and needs heating of media and the substrate. One disadvantage is decarburization or denitridisation of steel below diffusion coating, so pre-carburizing or pre-nitriding processes are applied in order to prevent this.

Coating and diffusion of the coated material can be realized in commercial PVD systems just by changing the amplitude negative bias voltage as explained in B. Çorlu, M. Ürgen, Surf. Coat. Technol. 204 (2009) 872; B. Çorlu, M. Ürgen, Surf. Coat. Technol. 205 (2010) 540., S. Akkaya, M.Ürgen et al, Surface & Coatings Technology 206 (2011) 1759-1764. Material evaporated from the cathode is deposited on the substrate during low negative voltage and can be heated when the bias voltage is in the high negative voltage mode. There is no cycle between negative and positive voltage values. Low and high voltage cycles can be changed from microseconds to seconds. However there are two problems with this technique also. When the low and high voltage modes are changing within tens of seconds, high temperature variations occurred on the substrate which causes deformation, high internal stress and changes in diffusion mechanism. If the cycle is changed in microseconds, it is possible to avoid temperature changes. Other problem is sputtering of the already deposited coating, so efficiency of the process is not high. DD233279 A3 discloses arc deposition of titanium nitride using positive and negative substrate bias. WO2011/084573 A1 discloses deposition of Ni and Al in a layered structure by arc deposition and subsequent heat treatment to provide interdiffusion. Hence, one of the objects of the present invention is elimination of the cumbersome and time consuming steps of the state of the art methods for producing diffusion based coatings such as, pack, over the pack, CVD, TD and salt bath processes. Another object of the present invention is increasing the efficiency and temperature stability of the process as compared to prior cathodic arc diffusion treatments in the literature.

More specifically, it is one of the objects of the present invention to obtain accelerated vacuum diffusion coating and surface modification procedures in the course of producing functional layers on substrates or working pieces.

Another object of the present invention is eliminating, or at least shortening, costly and cumbersome steps of the prior art techniques that require individually several steps for diffusion based coatings

Another object of the present invention is to develop a cold wall process where just the substrate is heated and allows energy saving.

One significant advantage of the present invention is possibility to make environment friendly process for production of bond coats by eliminating formation of metal halides compared to pack cementation and CVD based techniques.

A further object of the present invention is to provide a novel method for better controlling of substrate's temperature and minimizing the need for additional heating elements.

Further objectives and aspects of the current invention will be apparent from the description below. The foregoing objects are achieved through a novel method according to claim 1. According to the presently disclosed solution, substrates to be treated are connected to an AC or bipolar DC power supply so that the said substrates may be continuously and sequentially treated with electron bombardment and metal ion treatment cycles *simultaneously.*

### Brief Description of the Figures

Figure 1 is a schematic demonstration of a basic PVD arc device suitable for applying the method according to the present invention.
Figure 2 shows an exemplary diagram of Time vs. Voltage of a power source that is applicable to a substrate according to an embodiment of the present invention.
Figure 3 shows another exemplary diagram of Time vs. Voltage of a power source (asymmetrical AC) that is applicable to a substrate according to an embodiment of the present invention.
Figure 4 shows an exemplary diagram of Time vs. Voltage of a power source (asymmetrical bipolar pulsed DC) that is applicable to a substrate according to an embodiment of the present invention.
Figures 5, 6, 7 and 8 are schematic demonstrations of the process equipment for use in the methods according to various embodiments of the present invention.
Figures 9a, 9b and 9c are the SEM micrographs of the samples treated with 30 min, 60 min and 150 min of vacuum arc diffusion treatment, respectively, according to the single step procedure of Example 1.
Figures 10a, 10b and 10c are the XRD patterns obtained from analysis of the said samples according to the Example.
Figures 11 a and 11b are the SEM micrographs of the samples treated with 30 min, and 60 min of vacuum arc diffusion treatment, respectively, according to the single step procedure of Example 2.
Figures 12a and 12b are the Glow Discharge Optical Emission Spectroscopy (GDOES) depth profile of the sample treated according to the procedure of Example 2.

### Detailed Description of the Invention

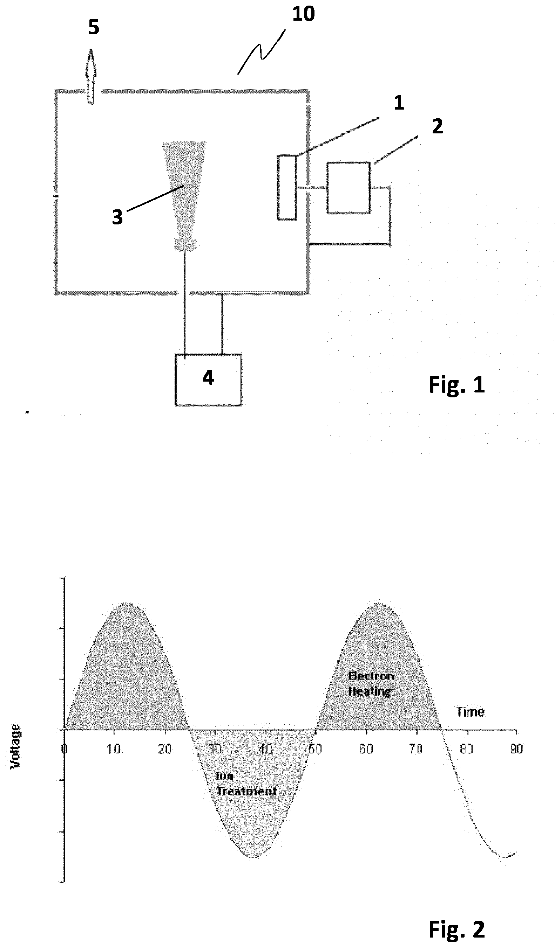

The present invention is realized in an evacuatable process chamber (10), optionally water cooled, with at least one consumable conductive target material or cathode (1) as a deposition source which is powered by an arc power supply (2) and is electrically insulated from the chamber, and a substrate (3) to be treated which is electrically insulated from the chamber and powered by an AC or bipolar pulsed DC bias power supply (4). According to the schematic presentation of the process equipment in Fig. 1, there is shown a very basic embodiment of the present invention wherein the aforesaid components are shown. The chamber (10) is also equipped with means (5) for evacuating it so that the pressure can be brought into vacuum conditions.

As may be appreciated by those skilled in the art, the AC or bipolar pulsed DC bias power supply (4) directly connected to the substrate (3) causes a change of polarity which advantageously changes the voltage on the said substrate (3). As shown in Fig. 2, bias voltage follows a sinusoidal pattern between positive and negatively charged states. Due to the changing polarity on the substrate, when the substrate bias is in positive polarity, electrons emitted from the target material or cathode (1) are attracted to substrate (3) and leads to electron heating of this substrate (3), and when the polarity of substrate (3) changes to negative the metal ions are attracted to the substrate (3). Deposition, etching, sputtering and/or heating occurs depending on the amplitude of the negative voltage applied on the substrate (3).

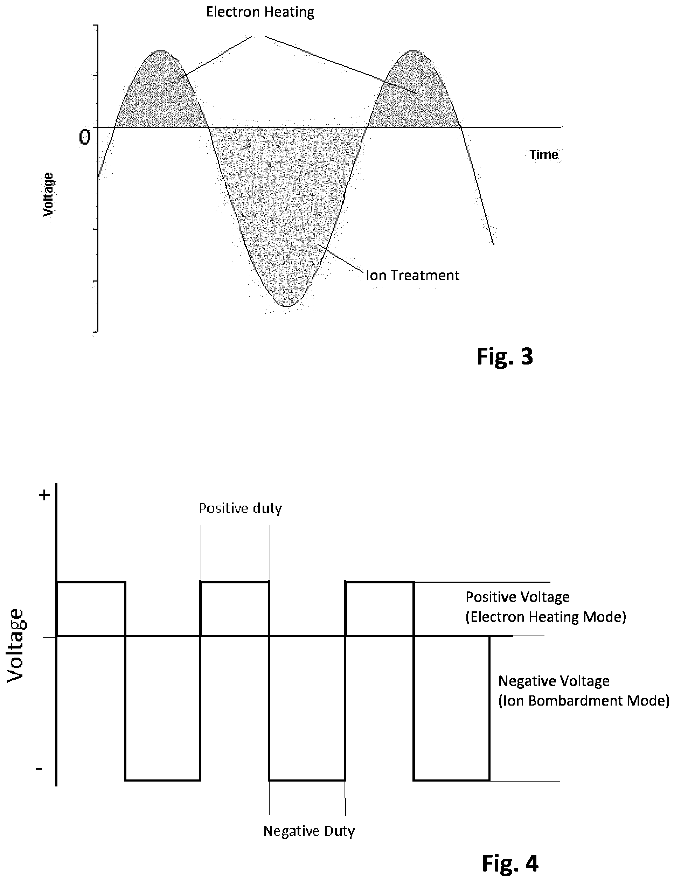

In another embodiment according to the present invention, the method provided herewith involves an asymmetrical AC power source producing a frequency from a few Hz to a few kHz, so the positive polarity electron current and negative polarity ion current on the substrate (3) are separately adjustable in order to set the electron heating and ion bombardment properties, thus deposition temperature, coating, resputtering, etching properties can be separately adjustable. As an exemplary demonstration of the sinusoidal pattern followed by the AC power source according to this embodiment, Fig. 3 is provided to show that amplitudes of positive and negative sides of the voltage or current may differ and vary asymmetrically such that temperature of the substrate may be adjusted with shorter intervals of electron treatment while ion treatment for surface modification may be applied with higher durations and higher currents.

In another embodiment of the present invention is provided a power supply (4) connected to the substrate (3) using an asymmetrical bipolar pulsed DC as shown in Fig. 4. The said power supply (4) has the capability of setting frequency, positive and negative pulse voltages and positive and negative duty cycles separately and allowing high electron currents during positive polarity. This allows more possibility to set the electron heating and ion bombardment properties, thus deposition temperature, coating, resputtering, etching properties can be separately adjustable.

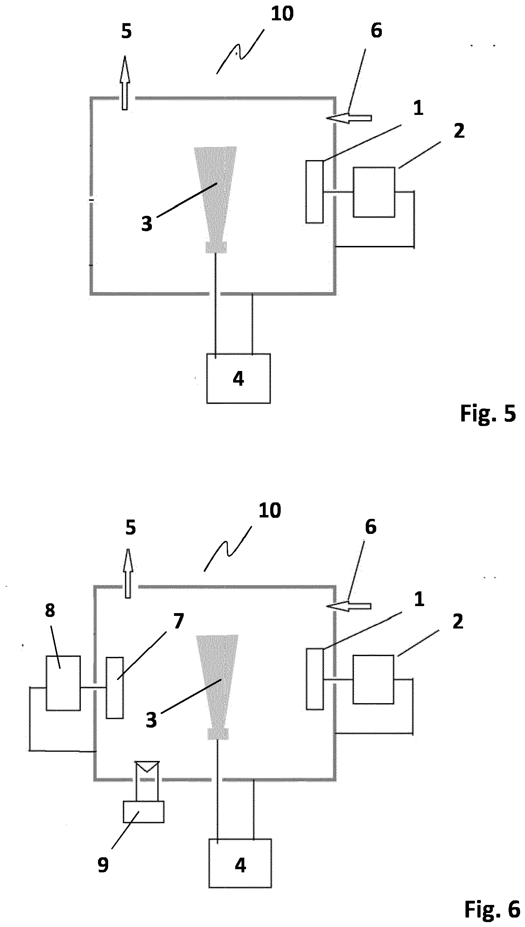

According to the embodiments of the present invention, the process chamber (10) is provided with gas feeding lines (6) to feed inert, reactive or precursor gases, as shown in Fig. 5, in order to improve coating quality, to coat alloys and compounds, and for doping additional coating materials. The process chamber (10) may also be equipped with additional arc or sputtering sources (7) powered by a separate power supply (8) and/or additional evaporators (9) (such as thermal, e-beam, laser), as shown in Fig. 6, for alloying and modifying deposited and diffused layers with single or multiple component materials such as Pt, Si, Y, Re, W etc.

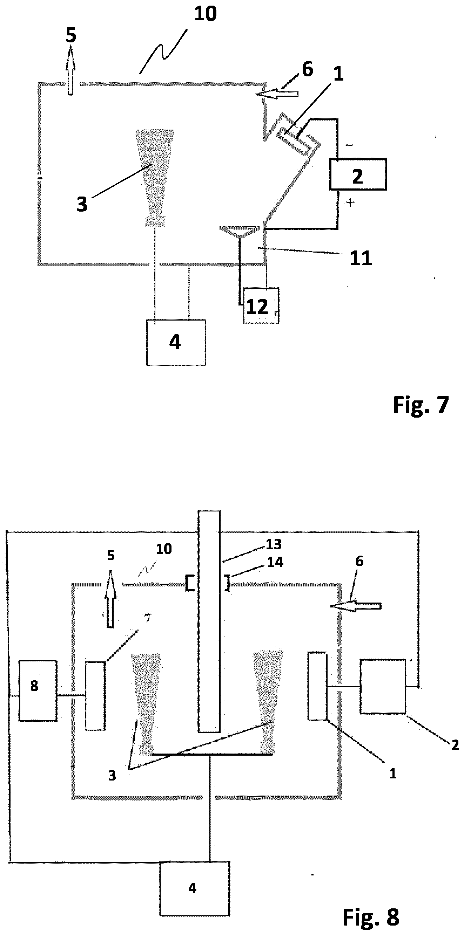

A conductive crucible (11) which is optionally water cooled and electrically insulated from the chamber (10) can also be provided as shown in Fig. 7. According to this embodiment, the said crucible (11) is located in line-of-sight with the arc source(s) without being in line-of-sight with the substrates (3). This crucible (11) filled with any evaporative material may advantageously be subjected to AC or bipolar DC voltage with a power supply (12), thus metal ions and droplets emitted from the arc cathode (1) will deposit and mix with the existing material in the crucible (11) and will allow to deposit an alloy that is composed of cathode material (1) and the material within the crucible (11). The inventors note that this configuration has surprisingly provided with shorter periods of treatment in the course of alloy deposition on the substrates (3), and has also benefits of high ionization rate and capability of coating compounds including low melting point elements which produces high amount of macroparticules in cathodic arc evaporation.

In another embodiment of the present invention an auxiliary anode (13) is insulated from the chamber by a water cooled feedthrough (14) and it connects the positive electrodes of the evaporator power supplies (2, 8) and one electrode of the bias supply (4) to the aforementioned auxiliary anode instead of grounded chamber (10) in order to prevent current flow through chamber and use this residual energy to heat stationary or rotating substrates (3).

In another embodiment of the present invention, it would be possible to deposit diamond coatings and free standing diamonds by using any arc source preferably filtered and applying AC or asymmetrical bipolar pulse DC bias to the substrate (3) and feeding carbon containing gases like CH₄ and C₂H₂. Optionally, by adding precursor gases containing dopant materials or by evaporating or sputtering dopant materials from extra sources it is possible to deposit doped diamond coatings or doped free standing diamonds.

Ni-Al bond coats are well known diffusion based coatings deposited on Nickel based high temperature alloys by pack cementation, over the pack or CVD deposition techniques. These techniques are based on deposition of Al on nickel based substrate from Al containing halogen gases, which are quite corrosive and poisonous. In most applications, long heat treatments are required to acquire desired beta NiAl phase. Total process time takes from 5 to 24 hours including coating and post heat treatment steps and causes high energy consumption. The embodiments of the present invention are applicable to produce diffusion based coatings such as single or multiple compounds of aluminides, borides, chromides etc. where the single component or alloy cathode materials are evaporated from the cathode and simultaneously deposited on and diffused into substrates with the help of electron heating and ion bombardment. Compound diffusion coatings and layers can be produced by evaporating alloys from single or multiple cathodes or evaporating pure different metals from different cathodes. As an example, turbine blade diffusion bond coats can be produced accordingly, with modifying elements such as Pt, Au, Ag, Si, W, Re.

It is also possible to produce coatings where the deposited material and some components of substrate materials react and form carbides, nitrides, oxides etc. For example, coatings such as vanadium carbide as conventionally produced by way of depositing vanadium from salt bath and reacting the same with carbides in a steel substrate can be produced within shortened periods according to the procedure of the current invention. These kind of coatings can be produced by evaporating single or multiple component cathode materials such as V, Mo, Ti, Cr, Zr, B so that deposited materials react with the components of substrate and form hard alloys, compounds or intermetallics and carbides, borides, oxides and nitrides. Optionally, reactive gases may be added inside the chamber (10) so that nitrides, oxides, carbides, oxynitrides and any combination thereof can be produced as a part of the coating.

As a consequence, the present invention allows coating and heat treatment in a single process which results in several advantages in terms of duration of the procedure and eliminating cumbersome process steps and equipment.

### Example 1

The procedure of the invention is applied for single step and environment friendly deposition of Ni-Al bond layers on a nickel based high temperature alloy (Inconel 600) for 30, 60 and 150 minutes in a commercial Arc PVD equipment. Al materials were evaporated from cathodic arc source, applying 90A DC evaporation current to Al cathode, and applying 25 to 30V AC bias power to the Inconel substrate. Deposition pressure was set to 5x10⁻⁴ Torr by feeding 20 SCCM inert argon gas to sustain the arc.

| **Sample No** | **Cathode Material** | **Substrate** | **Cathode Evaporation Current (A)** | **AC BIAS** | **Process Time (min)** | **Max Substrate Temp (°C)** |
|---|---|---|---|---|---|---|
| **PAC-1 375** | Al | Inconel 600 | 90 | 30 V /30 A | 30 | 1310 |
| **PAC-2 368** | Al | Inconel 600 | 90 | 25 V /22 A | 60 | 1135 |
| **PAC-3 376** | Al | Inconel 600 | 90 | 30 V / 30 A | 150 | 1260 |

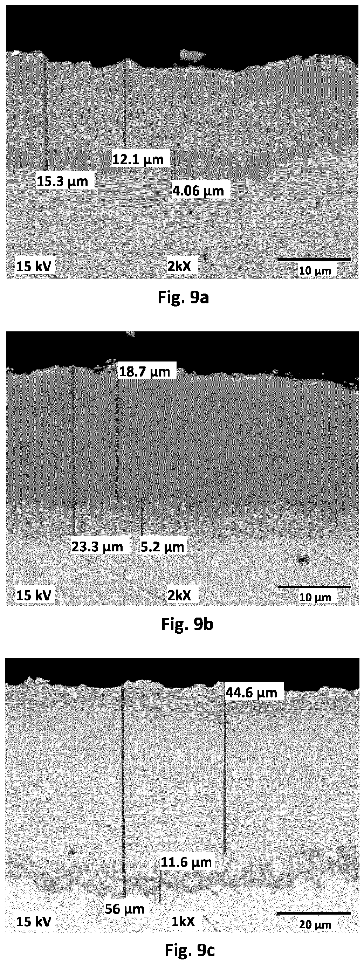

SEM micrographs of the mentioned diffusion coatings can be seen in Figures 9a, 9b and 9c. The figures show that Ni-Al coatings are produced in all samples, but with different thickness profiles. Typical inter-diffusion zones that are observed in Ni-Al bond coats produced by other techniques can also be seen in the present applications. On the other hand, thickness varies from 15.3 to 56 micrometer. As a consequence, a thickness of about 56µm is obtained within just 150 minutes, which shows that procedure of the current invention has a very prominent technical effect in Ni-Al bond layer coating procedures which generally requires several hours in conventional applications.

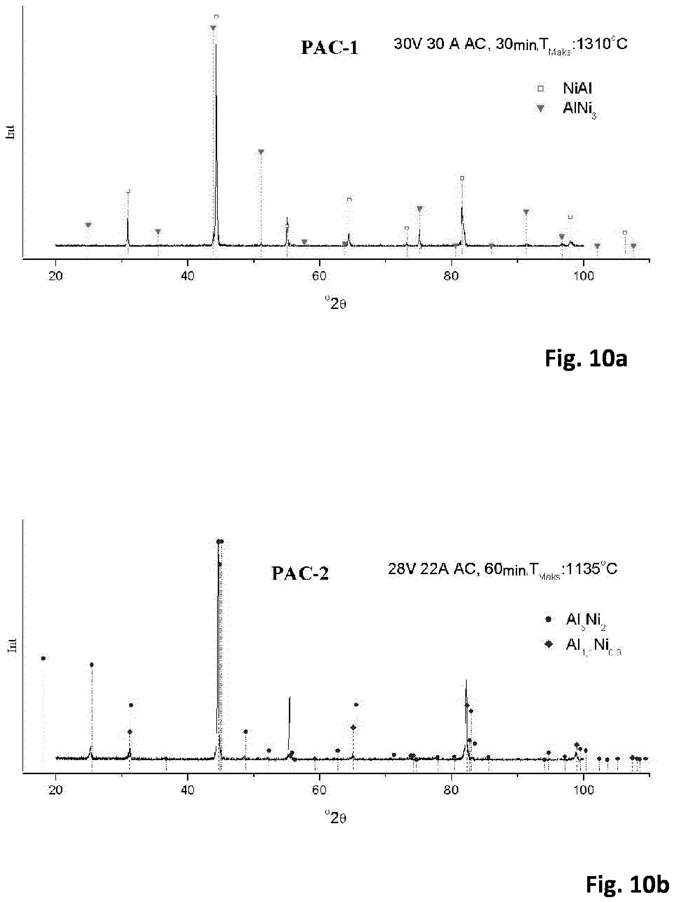

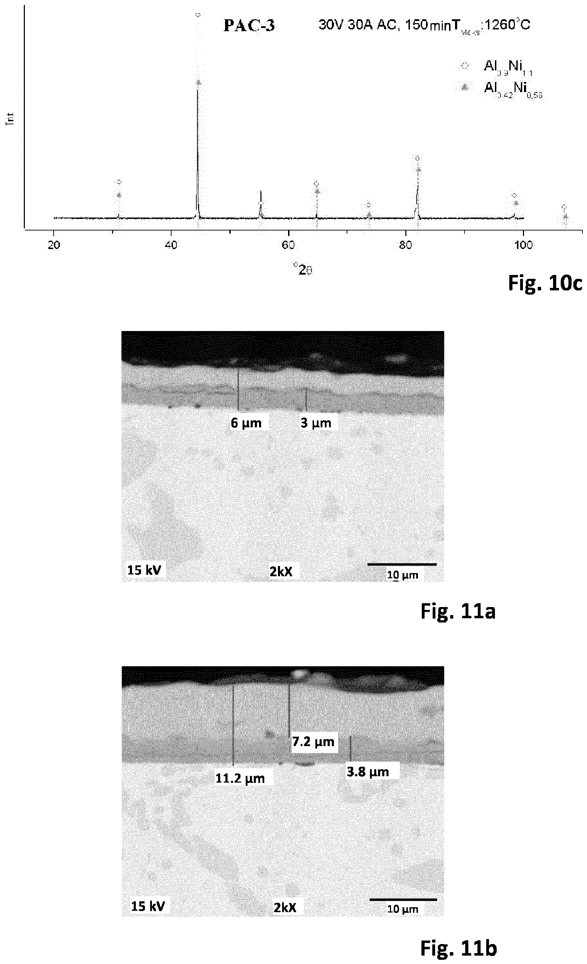

The phases in the deposited layers were examined by XRD in gonio mode from 20° to 100° by a Philips PW3710 XRD apparatus. As seen in the figures 9a and 10a, the sample/PAC-1 with 30 minutes deposition has a coating thickness of 15.3 µm which consists of AlNi and AlNi₃ phases. Referring to Fig. 10b, 60 minutes deposited PAC-2 has 23.3 µm thickness and having the phases of AlNi and Al₃Ni₂ due to lower substrate temperature. According to Fig. 10c, PAC-3 was deposited for 150 minutes, having 56 µm total thickness with Beta-AlNi phases as desired. The invention was successfully applied for production of Ni-Al bond coats on nickel based Inconel 600 alloy by a single step process. As seen in the example, by adjusting AC voltage, temperature of the process thus the diffusion parameters and kinetics can be easily controlled. This allows adjustment of the phases, compositions and stoichiometry of the mentioned NiAl bond layer.

By conventional methods such as pack aluminising, over the pack or CVD, total process time including coating and post heat treatment ranges from at least 8 to sometimes several tens of hours to achieve 50 µm NiAl bond coat. By the invented technique, 150 µm NiAl bond layer was coated in 150 minutes by single step process. It is possible to shorten this time when more than one arc cathode is used for deposition.

### Example 2

The procedure of the invention is applied for formation of TiC + Ti layers on 1.2379 cold work tool steel by coating pure Ti cathode evaporated at 90 A current for 30 and 60 minutes. 30 V AC bias was applied to the substrates to heat and keep the temperature at 1050°C which is regular austenization temperature for 1.2379 tool steel.

SEM micrographs of the examples are shown for 30 and 60 minutes treatment in Figures 11 a and 11b.

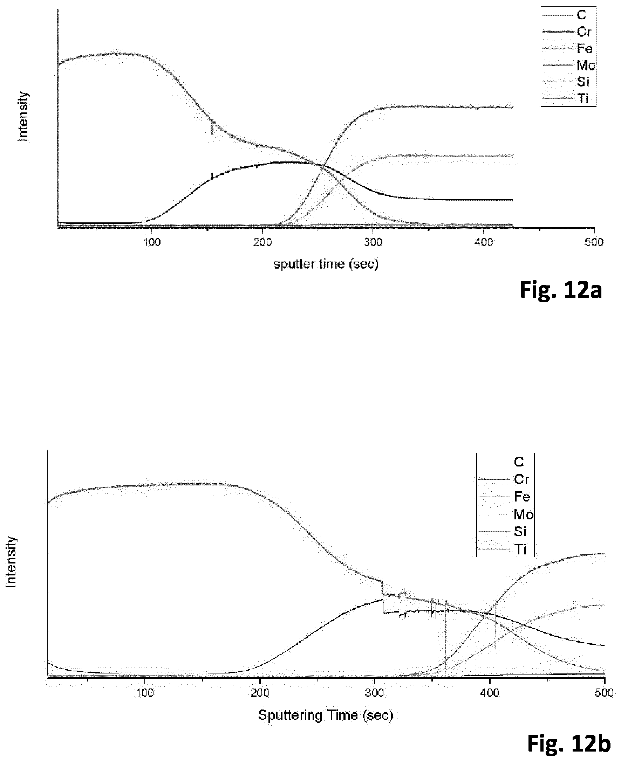

After 30 min treatment, a double layer formation was observed. First 3 µm Ti+C has been formed over the substrate by diffusion of C from substrate into the deposited Ti layer. A top layer of 3 µm Titanium is observed over diffusion layer. After 60 min treatment again a double layer formation was observed, first Ti + C layer is between 3-4 µm and top layer is 7-8 µm pure Titanium. GDOES Depth profile optical emission spectrum of the layers can be seen in Figures 12a and 12b respectively.

This example shows that it is possible to make carbide based layers where the carbon is diffused from substrate to the coating by the invented method.

The examples above also show capability of applying coating and heat treatment operations simultaneously. This combination will have many advantages like preventing oxidation and contamination over the substrates, as well as reducing the energy consumption for heating the substrates and reducing also the process time of the treatment procedure. In all other heat treatment techniques mainly resistive heaters are used to heat up all the chamber and substrates. The new invention allows preferential heating of substrates only.

## Claims

1. A method for production of a diffusion based coating comprising beta phase NiAl on a nickel based alloy substrate (3) in a vacuum chamber (10) having a consumable single component or alloyed target material comprising aluminum, which is powered by a power supply (2) and serving as a cathode (1), and a substrate (3) to be treated, the method comprising applying an AC or bipolar pulsed DC bias to the said substrate (3) during coating to establish cycles of positive and negative bias voltages until a beta phase of NiAl is obtained, whereby the substrate (3) is heated with electron bombardment in positive bias states and coated in negative bias states *in situ* with a cathodic arc treatment.

2. A method according to claim 1 wherein the method comprises applying of AC to the substrate (3) during the process to heat the substrate *in situ* by using emitted electrons.

3. A method according to claim 2 wherein the method comprises applying of an asymmetrical AC to the substrate (3) during process to heat the substrate *in situ* by using emitted electrons.

4. A method according to claims 1, 2 and 3 wherein the method comprises separate adjustment of frequency, amplitudes and intervals of the positive voltage bias for controlling electron heating steps and negative voltage bias for controlling coating step of substrate (3) when using AC power.

5. A method according to claim 1 wherein the method comprises applying of bipolar pulse power to the substrate (3) during process.

6. A method according to claims 1 and 5 wherein the method comprises applying of bipolar DC to the substrate (3) during the process to heat the substrate *in situ* by using emitted electrons, and further comprises separate adjustment of frequency, amplitudes and duty cycles of the positive voltage period of bias for controlling electron heating steps and negative voltage period of bias for controlling coating steps of substrate (3) when using bipolar pulse power.

7. A method according to claim 1 wherein the method further comprises feeding of inert, reactive or precursor gases during coating into the vacuum chamber to control process parameters and/or to make reactive coating and/or doping additional materials into deposited layers.

8. A method according to claim 1 wherein the method further comprises using of additional arc sources or sputtering sources (7) and/or evaporators (9) to incorporate additive materials to the coating that is produced on substrate (3) in the chamber (10).

9. A method according to any of the preceding claims wherein the method comprises production of diffusion based coatings formed through diffusion and or interdiffusion of the substrate components (3) and the coated materials within each other.

10. A method according to claim 1 wherein the method comprises applying an AC bias voltage ranging from 25 to 30 V for a duration ranging from 30 min. to 150 min.

## Patentansprüche

1. Verfahren zur Herstellung einer diffusionsbasierten Beschichtung, die eine NiAl-beta-Phase auf einem Nickel-Basierte-Legierung-Substrat (3) aufweist, in einer Vakuumkammer (10) mit einem verbrauchbaren Einzelkomponenten- oder Legierungszielmaterial, das Aluminium aufweist, die durch eine Stromversorgung (2) gespeist wird und als Kathode (1) dient, und einem zu behandelnden Substrat (3), wobei das Verfahren während des Beschichtens das Anlegen einer Wechselstrom- oder einer bipolaren gepulsten Gleichstromvorspannung an dem Substrat (3) aufweist, um Zyklen positiver und negativer Vorspannungsspannungen zu erzeugen, bis eine beta-Phase von NiAl erhalten wird, wodurch das Substrat (3) in positiven Vorspannungszuständen durch Elektronenbeschuss erwärmt und in negativen Vorspannungszuständen *in situ* mit einer Kathodenlichtbogenbehandlung beschichtet wird.

2. Verfahren gemäß Anspruch 1, wobei das Verfahren während des Prozesses das Anlegen von Wechselstrom an dem Substrat (3) aufweist, um das Substrat *in situ* unter Verwendung von emittierten Elektronen zu erwärmen.

3. Verfahren gemäß Anspruch 2, wobei das Verfahren während des Prozesses das Anlegen eines asymmetrischen Wechselstroms an dem Substrat (3) aufweist, um das Substrat *in situ* unter Verwendung von emittierten Elektronen zu erwärmen.

4. Verfahren gemäß Anspruch 1, 2 und 3, wobei das Verfahren eine getrennte Einstellung von Frequenz, Amplituden und Intervallen der positiven Spannungsvorspannung zum Steuern von Elektronenerwärmungsschritten und der negativen Spannungsvorspannung zum Steuern des Beschichtungsschritts des Substrats (3) bei Verwendung von Wechselstromleistung aufweist.

5. Verfahren gemäß Anspruch 1, wobei das Verfahren während des Prozesses das Anlegen von bipolarer Pulsleistung an dem Substrat (3) aufweist.

6. Verfahren gemäß Anspruch 1 und 5, wobei das Verfahren während des Prozesses das Anlegen von bipolarem Gleichstrom an dem Substrat (3) aufweist, um das Substrats *in situ* unter Verwendung von emittierten Elektronen zu erwärmen, und ferner eine getrennte Einstellung von Frequenz, Amplituden und Lastzyklen der positiven Spannungsperiode von Vorspannung zum Steuern von Elektronenerwärmungsschritten und der negativen Spannungsperiode von Vorspannung zum Steuern von Beschichtungsschritten des Substrats (3) bei Verwendung von bipolarer Pulsleistung aufweist.

7. Verfahren gemäß Anspruch 1, wobei das Verfahren während des Beschichtens ferner das Zuführen von inerten, reaktiven oder Vorläufergasen in die Vakuumkammer aufweist, um Prozessparameter zu steuern und/oder um reaktives Beschichten und/oder Dotieren zusätzlicher Materialien in abgeschiedene Schichten auszuführen.

8. Verfahren gemäß Anspruch 1, wobei das Verfahren ferner das Verwenden zusätzlicher Lichtbogenquellen oder Sputterquellen (7) und/oder Verdampfern (9) aufweist, um Zusatzmaterialien in die Beschichtung einzubinden, die auf dem Substrat (3) in der Kammer (10) erzeugt wird.

9. Verfahren gemäß einem der vorhergehenden Ansprüche, wobei das Verfahren das Herstellen von diffusionsbasierten Beschichtungen aufweist, die durch Diffusion und/oder Interdiffusion der Substratkomponenten (3) und der beschichteten Materialien untereinander gebildet werden.

10. Verfahren gemäß Anspruch 1, wobei das Verfahren das Anlegen einer Wechselvorspannungsspannung im Bereich von 25 bis 30 V für eine Dauer im Bereich von 30 Minuten bis 150 Minuten aufweist.

## Revendications

1. Procédé de production d'un revêtement à base de diffusion comprenant du NiAl en phase bêta sur un substrat en alliage à base de nickel (3) dans une chambre à vide (10) ayant un seul composant consommable ou un matériau cible allié comprenant de l'aluminium, qui est alimenté par une alimentation électrique (2) et servant de cathode (1), et un substrat (3) à traiter, le procédé comprenant l'application d'une polarisation en courant alternatif ou en courant continu pulsé bipolaire audit substrat (3) pendant le revêtement pour établir des cycles de tensions de polarisation positive et négative jusqu'à ce qu'une phase bêta du NiAl soit obtenue, moyennant quoi le substrat (3) est chauffé avec un bombardement électronique dans les états de polarisation positive et revêtu dans les états de polarisation négative *in situ* avec un traitement à arc cathodique.

2. Procédé selon la revendication 1, le procédé comprenant l'application d'un courant alternatif au substrat (3) pendant le processus de chauffage du substrat *in situ* en utilisant des électrons émis.

3. Procédé selon la revendication 2, le procédé comprenant l'application d'un courant alternatif asymétrique au substrat (3) pendant le processus de chauffage du substrat *in situ* en utilisant des électrons émis.

4. Procédé selon les revendications 1, 2 et 3, le procédé comprenant un ajustement séparé de la fréquence, des amplitudes et des intervalles de la polarisation en tension positive pour commander les étapes de chauffage électronique et de la polarisation en tension négative pour commander l'étape de revêtement du substrat (3) lors de l'utilisation de l'alimentation en courant alternatif.

5. Procédé selon la revendication 1, le procédé comprenant l'application d'une puissance d'impulsion bipolaire au substrat (3) pendant le processus.

6. Procédé selon les revendications 1 et 5, le procédé comprenant l'application d'un courant continu bipolaire au substrat (3) pendant le processus de chauffage du substrat *in situ* en utilisant des électrons émis, et comprenant en outre un ajustement séparé de la fréquence, des amplitudes et des cycles de service de la période de polarisation en tension positive pour commander les étapes de chauffage électronique et de la période de polarisation en tension négative pour commander les étapes de revêtement du substrat (3) lors de l'utilisation d'une puissance d'impulsion bipolaire.

7. Procédé selon la revendication 1, le procédé comprenant en outre le fait de fournir des gaz inertes, réactifs ou précurseurs pendant le revêtement dans la chambre à vide pour commander les paramètres du processus et/ou fabriquer un revêtement réactif et/ou doper des matériaux supplémentaires dans des couches déposées.

8. Procédé selon la revendication 1, le procédé comprenant en outre l'utilisation de sources d'arc ou de sources de pulvérisation cathodique (7) et/ou d'évaporateurs (9) supplémentaires pour incorporer des matériaux additifs au revêtement qui est produit sur le substrat (3) dans la chambre (10).

9. Procédé selon l'une des revendications précédentes, le procédé comprenant la production de revêtements à base de diffusion formés par diffusion et/ou interdiffusion des composants de substrat (3) et des matériaux revêtus les uns dans les autres.

10. Procédé selon la revendication 1, le procédé comprenant l'application d'une tension de polarisation en courant alternatif se trouvant dans la plage allant de 25 à 30 V pendant une durée allant de 30 minutes à 150 minutes.
